(19) Europäisches Patentamt / European Patent Office / Office européen des brevets

(11) **EP 4 152 908 A1**

(12) **EUROPEAN PATENT APPLICATION**
published in accordance with Art. 153(4) EPC

(43) Date of publication:
**22.03.2023 Bulletin 2023/12**

(21) Application number: **21804603.5**

(22) Date of filing: **13.05.2021**

(51) International Patent Classification (IPC):
**H05K 9/00** (2006.01)    **C01G 49/00** (2006.01)
**C01G 49/06** (2006.01)    **H01F 1/28** (2006.01)

(52) Cooperative Patent Classification (CPC):
**C01G 49/00; C01G 49/06; H01F 1/28; H05K 9/00**

(86) International application number:
**PCT/JP2021/018230**

(87) International publication number:
**WO 2021/230320 (18.11.2021 Gazette 2021/46)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.05.2020   JP 2020084720**

(71) Applicants:
• **The University of Tokyo**
  **Bunkyo-ku, Tokyo 113-8654 (JP)**
• **TOKYO OHKA KOGYO CO., LTD.**
  **Kawasaki-shi, Kanagawa 211 0012 (JP)**

(72) Inventors:
• **OHKOSHI, Shin-ichi**
  **Tokyo 113-8654 (JP)**
• **NAMAI, Asuka**
  **Tokyo 113-8654 (JP)**
• **YOSHIKIYO, Marie**
  **Tokyo 113-8654 (JP)**
• **HARA, Masayuki**
  **Kawasaki-shi, Kanagawa 211-0012 (JP)**
• **ASAI, Takahiro**
  **Kawasaki-shi, Kanagawa 211-0012 (JP)**

(74) Representative: **Plasseraud IP**
**66, rue de la Chaussée d'Antin**
**75440 Paris Cedex 09 (FR)**

(54) **ELECTROMAGNETIC WAVE ABSORBER AND PASTE FOR FORMING ELECTROMAGNETIC WAVE ABSORBER**

(57)    The purpose of the present invention is to provide a radio wave absorber with which it is possible to obtain both excellent radio wave absorption characteristics in a highfrequency band and excellent heat dissipation characteristics, and a radio wave absorber formation paste suitable for use in producing the radio wave absorber. A radio wave absorber is provided with a composite layer made of a radio wave absorption material and a thermally conductive material, the radio wave absorption material being made to contain one or more types of epsilon-type iron oxide selected from: $\varepsilon$-Fe$_2$O$_3$ crystal; and a crystal in which the crystal and the space group are identical to those of $\varepsilon$-Fe$_2$O$_3$ and a part of an Fe site of the $\varepsilon$-Fe$_2$O$_3$ is substituted with an element M other than Fe, and that is represented by the formula $\varepsilon$-M$_x$Fe$_{2-x}$O$_3$, x being above 0 and below 2.

FIG. 1

**Description**

TECHNICAL FIELD

The present invention relates to a radio wave absorber and a radio wave absorber forming paste.

BACKGROUND ART

Radio waves in a high-frequency band are increasingly being used in various information communication systems such as cellular telephones, wireless local area networks (LANs), electronic throttle control (ETC) systems, intelligent transport systems, driving support road systems, satellite broadcasting, and the like. However, the increasing use of the radio waves in a high-frequency band involves a risk of failure and malfunction of electronic devices due to interference between electronic parts. In order to address such a problem, a method of absorbing unnecessary radio waves by a radio wave absorber has been employed.

Accordingly, in a radar or the like using the radio waves in a high-frequency band, radio wave absorbers have been used in order to reduce the influence of unnecessary radio waves that should not be received. In order to meet such a demand, various radio wave absorbers capable of satisfactorily absorbing the radio waves in a high-frequency band have been proposed. Well-known specific examples thereof include radio wave absorbing sheets including a carbon nano-coil and a resin (e.g., Patent Document 1).

Among applications of the radio waves in a high-frequency band, research on operation support systems for automobiles has progressed. In such operation support systems for automobiles, radio waves in a 76-GHz band have been utilized in automotive radars for detecting an inter-vehicular distance and the like. In various applications not just limited to the operation support systems, the radio waves in a high-frequency band, for example, in 100 GHz or higher are expected to be increasingly used. Therefore, there is a need for radio wave absorbers capable of satisfactorily absorbing radio waves in the 76-GHz band or higher frequency band.

In order to meet such a demand, for example, a radio wave absorber that includes a radio wave absorbing layer including a magnetic crystal composed of $\varepsilon$-$Fe_2O_3$-based iron oxide has been proposed as a radio wave absorber capable of satisfactorily absorbing radio waves over a wide range in a high-frequency band (e.g., Patent Document 2 and Non-Patent Documents 1 to 3).

Patent Document 1: Japanese Unexamined Patent Application, Publication No. 2009-060060
Patent Document 2: Japanese Unexamined Patent Application, Publication No. 2008-277726

Non-Patent Document 1:
A.Namai,S.Sakurai,M.Nakajima,T.Suemoto,K.Matsumoto,M.Goto,S.Sa        saki,        and        S.Ohkoshi, J.Am.Chem.Soc.,131,1170-1173(2009).
Non-Patent Document 2:
A.Namai,M.Yoshikiyo,K.Yamada,S.Sakurai,T.Goto,T.Yoshida,T.Miya zaki,M.Nakajima,T.Suemoto,H.Tokoro, and S.Ohkoshi, Nature Communications,3,1035/1-6(2012).
Non-Patent Document 3:
S.Ohkoshi,S.Kuroki,S.Sakurai,K.Matsumoto,K.Sato, and S.Sasaki, Angew.Chem.Int.Ed.,46,8392-8395(2007).
Non-Patent Document 4: A.Namai,K.Ogata,M.Yoshikiyo, and S.Ohkoshi, Bull.Chem.Soc.Jpn.,93,20-25(2020).

DISCLOSURE OF THE INVENTION

Problems to be Solved by the Invention

However, in the radio wave absorber as described in Patent Document 1, heat is accumulated in the radio wave absorber depending on the use environment in some cases. When heat is accumulated in the radio wave absorber, a material constituting the radio wave absorber deforms or deteriorates in some cases. Further, the radio wave absorber accumulates heat to adversely affect the entire apparatus in some cases. Therefore, it is strongly desired to impart a heat dissipation property to the radio wave absorber without excessively impairing good radio wave absorption characteristics of the radio wave absorber in a high frequency band.

The present invention has been made in view of the above-mentioned problems of the prior art, and it is an object of the present invention to provide a radio wave absorber capable of achieving both good radio wave absorption characteristics in a high-frequency band and good heat dissipation characteristics, as well as a radio wave absorber forming paste which can be suitably used in the production of the radio wave absorber.

Means for Solving the Problems

The present inventors have found that the above-mentioned problems can be solved by providing the radio wave absorber with a composite layer including a radio wave absorbing material and a thermally conductive material, and blending, in the radio wave absorbing material, at least one epsilon-type iron oxide selected from the group consisting of an $\varepsilon\text{-}Fe_2O_3$ crystal and a crystal represented by formula $\varepsilon\text{-}M_xFe_{2-x}O_3$, in which x is greater than 0 and less than 2, the crystal represented by $\varepsilon\text{-}M_xFe_{2-x}O_3$ having an identical crystal structure and space group to those of the $\varepsilon\text{-}Fe_2O_3$ crystal, some of Fe sites thereof being substituted with an elemental M other than Fe.

A first aspect of the present invention relates to a radio wave absorber, including a composite layer including:

a radio wave absorbing material and a thermally conductive material,
the radio wave absorbing material including epsilon-type iron oxide,
the epsilon-type iron oxide being at least one selected from the group consisting of an $\varepsilon\text{-}Fe_2O_3$ crystal and a crystal represented by formula $\varepsilon\text{-}M_xFe_{2-x}O_3$, in which x is greater than 0 and less than 2, the crystal represented by $\varepsilon\text{-}M_xFe_{2-x}O_3$ having an identical crystal structure and space group to those of the $\varepsilon\text{-}Fe_2O_3$ crystal, some of Fe sites thereof being substituted with an elemental M other than Fe.

A second aspect of the present invention relates to a radio wave absorber forming paste,

the paste including a radio wave absorbing material and a thermally conductive material,
the radio wave absorbing material including epsilon-type iron oxide,
the epsilon-type iron oxide being at least one selected from the group consisting of an $\varepsilon\text{-}Fe_2O_3$ crystal and a crystal represented by formula $\varepsilon\text{-}M_xFe_{2-x}O_3$, in which x is greater than 0 and less than 2, the crystal represented by $\varepsilon\text{-}M_xFe_{2-x}O_3$ having an identical crystal structure and space group to those of the $\varepsilon\text{-}Fe_2O_3$ crystal, some of Fe sites thereof being substituted with an elemental M other than Fe.

Effects of the Invention

According to the present invention, it is possible to provide a radio wave absorber which has both excellent radio wave absorbing characteristics in a high frequency band and good heat dissipation, and provide a radio wave absorber forming paste that is suitably used for the production of the radio waver absorber.

BRIEF DESCRIPTION OF THE DRAWINGS

FIG. 1 is a graph illustrating reflection loss of the film-shaped radio wave absorber of Example 1;
FIG. 2 is a graph illustrating reflection loss of the film-shaped radio wave absorber of Example 3;
FIG. 3 is a graph illustrating reflection loss of the film-shaped radio wave absorber of Example 4;
FIG. 4 is a graph illustrating reflection loss of the film-shaped radio wave absorber of Example 5;
FIG. 5 is a graph illustrating reflection loss of the film-shaped radio wave absorber of Example 6;
FIG. 6 is a graph illustrating reflection loss of the film-shaped radio wave absorber of Example 7;
FIG. 7 is a graph illustrating reflection loss of the film-shaped radio wave absorber of Example 8;
FIG. 8 is a graph illustrating reflection loss of the film-shaped radio wave absorber of Example 9; and
FIG. 9 is a graph illustrating reflection loss of the film-shaped radio wave absorber of Example 10.

PREFERRED MODE FOR CARRYING OUT THE INVENTION

Although embodiments of the present invention will be described hereafter in detail, the present invention is not limited to the embodiments below in any way and can be implemented with modifications as appropriate within the scope of the object of the present invention.

<<Radio Wave Absorber>>

The radio wave absorber includes a composite layer including a radio wave absorbing material and a thermally conductive material. The radio wave absorber may consist of such a composite layer or may include a substrate layer supporting the composite layer.

For the radio wave absorber, a frequency band is preferably 30 gigahertz (GHz) or more, preferably 30 GHz or more and 300 GHz or less, and more preferably 40 GHz or more and 200 GHz or less, from the viewpoint of the possibility of more secure absorption of radio waves at high frequencies in a millimeter-wave band or higher. Preferably, there is a peak at which an absolute value of reflection loss of the radio wave absorber is 15 dB or more. Note that the reflection loss is a value measured on a surface on which the composite layer is exposed.

The shape of the radio wave absorber is not particularly limited and has preferably a sheet shape or a film shape, and more preferably a film-like shape. When the shape of the radio wave absorber is a film shape, the shape of film may have a curved surface or be only composed of a planar surface, and is preferably a flat plate shape. A thickness of the film as the radio wave absorber is preferably 1000 um or less, more preferably 900 um or less, further preferably 450 um or less, and particularly preferably 300 um or less from the viewpoint of thinning or downsizing of the film without impairing the effect of the present invention. The film thickness as the radio wave absorber may be uniform or ununiform.

<Composite Layer>

As described above, the composite layer includes a radio wave absorbing material and a thermally conductive material. The shape of the composite layer is not particularly limited. The composite layer may be either a laminate type including at least one layer consisting of a radio wave absorbing material and at least one layer including a thermally conductive material, or a single layer type including a radio wave absorbing material and a thermally conductive material. The composite layer is preferably a single layer type including a radio wave absorbing material and a thermally conductive material, since heat accumulated in the radio wave absorber can be evenly and efficiently radiated.

A thickness of the composite layer is not particularly limited without interfering with the objective of the present invention. The thickness of the composite layer is preferably 100 um or less and more preferably 50 um or less from the viewpoint of a balance of thinning and radio wave absorbing performance of the radio wave absorber. The lower limit of the thickness of the composite layer is not particularly limited without impairing the effect of the present invention, but is, for example, 1 um or more, 10 um or more, or the like. The thickness of the composite layer may be uniform or ununiform.

Below, optional or essential configurations of the composite layer will be described.

[Radio Wave Absorbing Material]

The radio wave absorbing material includes epsilon-type iron oxide. The radio wave absorber that includes a composite layer that includes a radio wave absorbing material that includes epsilon-type iron oxide satisfactorily absorbs radio waves in a frequency band of millimeter wave band or higher frequency. Additionally, the radio wave absorption characteristics are not easily inhibited even when the radio wave absorbing material is used in combination with a thermally conductive material described below.

In addition to the epsilon-type iron oxide, the radio wave absorbing material may include a magnetic substance having an ability to absorb radio waves. Examples of the magnetic substance that can be used along with the epsilon-type iron oxide include a barium ferrite magnetic substance and a strontium ferrite magnetic substance. From the viewpoint of good radio wave absorbing characteristics of the radio wave absorber, the ratio of a mass of the epsilon-type iron oxide with respect to a total of the mass of the epsilon-type iron oxide and a mass of the magnetic substance other than the epsilon-type iron oxide is preferably 70% by mass or more, more preferably 80% by mass or more, more preferably 90% by mass or more, more preferably 95 % by mass or more, and the most preferably 100% by mass.

In order to evenly disperse the epsilon-type iron oxide in the radio wave absorbing material, and in order to make the composite layer easily moldable, the radio wave absorbing material preferably includes a binder resin.

Below, the epsilon-type iron oxide and the binder resin as main materials to form the radio wave absorbing material, will be described.

(Epsilon-Type Iron Oxide)

The epsilon-type iron oxide is preferably at least one selected from the group consisting of an $\varepsilon$-$Fe_2O_3$ crystal; and a crystal of which crystalline structure and space group are the same as those of the $\varepsilon$-$Fe_2O_3$ crystal, in which a part of Fe sites in the $\varepsilon$-$Fe_2O_3$ crystal is substituted by an element M other than Fe, and which is represented by a formula $\varepsilon$-$M_xFe_{2-x}O_3$ wherein x is 0 or more and 2 or less and preferably 0 or more and less than 2. Since crystals of the epsilon-type iron oxide are magnetic crystals, such crystals may also be referred to as "magnetic crystals" herein.

Any $\varepsilon$-$Fe_2O_3$ crystals can be used. The crystal of which crystalline structure and space group are the same as those of the $\varepsilon$-$Fe_2O_3$ crystal, in which a part of Fe sites in the $\varepsilon$-$Fe_2O_3$ crystal is substituted by an element M other than Fe, and which is represented by a formula $\varepsilon$-$M_xFe_{2-x}O_3$ wherein x is 0 or more and 2 or less and preferably 0 or more and less than 2, is described later. It should be noted that $\varepsilon\text{-}M_xFe_{2-x}O_3$, in which a part of Fe sites in the $\varepsilon\text{-}Fe_2O_3$ crystal is substituted by a substitution element M, is also referred to as "M-substituted $\varepsilon\text{-}Fe_2O_3$" herein.

A particle size of a particle having the $\varepsilon\text{-}Fe_2O_3$ crystal and/or the M-substituted $\varepsilon\text{-}Fe_2O_3$ crystal in a magnetic phase is not particularly limited without interfering with the objective of the present invention. For example, an average particle size, as measured from a TEM (transmission electron microscope) photograph, of a particle having a magnetic crystal of epsilon-type iron oxide in a magnetic phase, which is manufactured by way of a method to be described later, is within a range of 5 nm or more and 200 nm or less. Furthermore, a variation coefficient (standard deviation of particle size/average particle size) of the particles each having a magnetic crystal of epsilon-type iron oxide in a magnetic phase, which is manufactured by way of the method to be described later, is within a range of less than 80%, which means that the particles are relatively fine and uniform in particle size.

The preferable composite layer use powder of such magnetic particles of epsilon-type iron oxide (in other words, particles having an $\varepsilon\text{-}Fe_2O_3$ crystal and/or an M-substituted $\varepsilon\text{-}Fe_2O_3$ crystal in a magnetic phase) as the magnetic substance, the radio wave absorbing material in the composite layer. As used herein, the "magnetic phase" is a part of the powder that carries a magnetic property. "Having an $\varepsilon\text{-}Fe_2O_3$ crystal and/or an M-substituted $\varepsilon\text{-}Fe_2O_3$ crystal in a magnetic phase" means that the magnetic phase is composed of an $\varepsilon\text{-}Fe_2O_3$ crystal and/or an M-substituted $\varepsilon\text{-}Fe_2O_3$ crystal, and includes a case in which an impurity magnetic crystal, which is inevitable in manufacturing, is mixed into the magnetic phase.

The magnetic crystal of epsilon-type iron oxide may include an impurity crystal of iron oxide having a space group and an oxidized state different from those of the $\varepsilon\text{-}Fe_2O_3$ crystal (specifically, $\alpha\text{-}Fe_2O_3$, $\gamma\text{-}Fe_2O_3$, FeO, and $Fe_3O_4$ crystals, as well as such crystals in which a part of Fe is substituted by other elements). In a case in which the magnetic crystal of epsilon-type iron oxide includes the impurity crystal, a main phase is preferably a magnetic crystal of $\varepsilon\text{-}Fe_2O_3$ and/or M-substituted $\varepsilon\text{-}Fe_2O_3$. In other words, in the magnetic crystal of epsilon-type iron oxide constituting the radio wave absorbing material, a ratio of the magnetic crystal of $\varepsilon\text{-}Fe_2O_3$ and/or M-substituted $\varepsilon\text{-}Fe_2O_3$ is preferably 50 mol% or more in a molar ratio as a compound.

An abundance ratio of crystals can be obtained by analysis through the Rietveld method based on X-ray diffraction pattern. Non-magnetic compounds generated in a sol-gel process such as silica ($SiO_2$) may be attached around the magnetic phase.

(M-substituted $\varepsilon\text{-}Fe_2O_3$)

As long as the M-substituted $\varepsilon\text{-}Fe_2O_3$ satisfies the conditions that a crystalline structure and a space group are the same as those of the $\varepsilon\text{-}Fe_2O_3$ crystal, and that a part of Fe sites in the $\varepsilon\text{-}Fe_2O_3$ crystal is substituted by an element M other than Fe, a type of the element M in the M-substituted $\varepsilon\text{-}Fe_3O_3$ is not particularly limited. The M-substituted $\varepsilon\text{-}Fe_2O_3$ may include a plurality of types of element M other than Fe.

Preferred examples of the element M include In, Ga, Al, Sc, Cr, Sm, Yb, Ce, Ru, Rh, Ti, Co, Ni, Mn, Zn, Zr, and Y. Among these, In, Ga, Al, Ti, Co, and Rh are preferable. In a case in which M is Al, in a composition represented by $\varepsilon\text{-}M_xFe_{2-x}O_3$, x is preferably within a range of, for example, 0 or more and less than 0.8. In a case in which M is Ga, x is preferably within a range of, for example, 0 or more and less than 0.8. In a case in which M is In, x is preferably within a range of, for example, 0 or more and less than 0.3. In a case in which M is Rh, x is preferably within a range of, for example, 0 or more and less than 0.3. In a case in which M is Ti and Co, x is preferably within a range of, for example, 0 or more and less than 1.

The frequency at which a radio wave absorption amount is maximum can be adjusted by adjusting at least one of a type and a substitution amount of the element M in the M-substituted $\varepsilon\text{-}Fe_2O_3$.

Such an M-substituted $\varepsilon\text{-}Fe_2O_3$ magnetic crystal can be synthesized by, for example, a combined process of a reverse micelle method and the sol-gel method described later, as well as a calcination process. The M-substituted $\varepsilon\text{-}Fe_2O_3$ magnetic crystal can also be synthesized by a combined process of a direct synthesis method and the sol-gel method as disclosed in Japanese Unexamined Patent Application Publication No. 2008-174405, as well as a calcination process.

Specifically, the M-substituted $\varepsilon\text{-}Fe_2O_3$ magnetic crystal can be obtained by a combined process of the reverse micelle method and the sol-gel method as well as a calcination process, as disclosed in Jian Jin, Shinichi Ohkoshi and Kazuhito Hashimoto, ADVANCED MATERIALS 2004, 16, No. 1, January 5, pp. 48-51; Shin-ichi Ohkoshi, Shunsuke Sakurai, Jian Jin, Kazuhito Hashimoto, JOURNAL OF APPLIED PHYSICS, 97, 10K312 (2005); Shunsuke Sakurai, Jian Jin, Kazuhito Hashimoto, and Shinichi Ohkoshi, JOURNAL OF THE PHYSICAL SOCIETY OF JAPAN, Vol. 74, No. 7, July 2005, pp. 1946-1949; Asuka Namai, Shunsuke Sakurai, Makoto Nakajima, Tohru Suemoto, Kazuyuki Matsumoto, Masahiro Goto, Shinya Sasaki, and Shinichi Ohkoshi, Journal of the American Chemical Society, Vol. 131, pp. 1170-1173, 2009; and the like.

In the reverse micelle method, two types of micellar solutions including a surfactant, i.e., a micellar solution I (raw material micelle) and a micellar solution II (neutralizer micelle) are blended, thereby causing precipitation reaction of iron hydroxide in a micelle. Thereafter, surfaces of iron hydroxide particulates generated in the micelle are subjected to silica coating, by the sol-gel method. The iron hydroxide particulates with a silica coating layer are separated from liquid and then subjected to heat treatment in an atmospheric environment at a predetermined temperature (within a range of 700 to 1300°C). This heat treatment creates $\varepsilon$-Fe$_2$O$_3$ crystal particulates.

More specifically, the M-substituted $\varepsilon$-Fe$_2$O$_3$ magnetic crystal is manufactured, for example, as follows.

First, in an aqueous phase of the micellar solution I with an oil phase being n-octane: iron (III) nitrate as an iron source; M nitrate as an M element source for substituting a part of iron (in the case of Al, aluminum (III) nitrate nonahydrate; in the case of Ga, gallium (III) nitrate hydrate; in the case of In, indium (III) nitrate trihydrate); and in the case of Ti and Co, titanium (IV) sulfate hydrate and cobalt (II) nitrate hexahydrate; and a surfactant (e.g., cetyltrimethylammonium bromide) are dissolved.

An appropriate amount of nitrate of an alkali earth metal (Ba, Sr, Ca, etc.) can be dissolved in advance in an aqueous phase of the micellar solution I. The nitrate functions as a shape controlling agent. Under the presence of the alkali earth metal in the solution, rod-shaped particles of the M-substituted $\varepsilon$-Fe$_2$O$_3$ magnetic crystal are finally obtained. Without any shape controlling agent, near-spherical particles of the M-substituted $\varepsilon$-Fe$_2$O$_3$ magnetic crystal are obtained.

The alkali earth metal added as the shape controlling agent may remain on a surface portion of the M-substituted $\varepsilon$-Fe$_3$O$_3$ magnetic crystal being generated. A mass of the alkali earth metal in the M-substituted $\varepsilon$-Fe$_2$O$_3$ magnetic crystal is preferably 20% by mass or less and more preferably 10% by mass or less with respect to a total mass of the substitution element M and Fe in the M-substituted $\varepsilon$-Fe$_2$O$_3$ magnetic crystal.

Ammonia aqueous solution is used as an aqueous phase of the micellar solution II with an oil phase being n-octane.

After blending the micellar solution I and the micellar solution II, the sol-gel method is applied. That is, stirring is continued during dropwise addition of silane (e.g., tetraethyl orthosilane) to the micellar solution mixture, thereby causing formation reaction of iron hydroxide or element M-containing iron hydroxide in a micelle. As a result, surfaces of precipitated particulates of iron hydroxide generated in the micelle are coated with silica generated by hydrolysis of the silane.

Thereafter, particle powder obtained by separating from liquid, washing, and then drying the silica-coated M element-containing iron hydroxide particles is fed into a furnace, and subjected to heat treatment (calcination) in the air within a temperature range of 700°C or more and 1300°C or less, preferably 900°C or more and 1200°C or less, and further preferably 950°C or more and 1150°C or less. The heat treatment causes an oxidation reaction in the silica coating, thereby changing particulates of the M element-containing iron hydroxide into particulates of the M-substituted $\varepsilon$-Fe$_2$O$_3$.

Upon this oxidation reaction, the silica coating contributes to generation of an M-substituted $\varepsilon$-Fe$_2$O$_3$ crystal having the same space group as that of $\varepsilon$-Fe$_2$O$_3$, instead of $\alpha$-Fe$_3$O$_3$ or $\gamma$-Fe$_2$O$_3$ crystal, and has also an effect of preventing sintering of particles. In addition, an appropriate amount of an alkali earth metal promotes growth of the particles in a rod-like shape.

In addition, as described above, the M-substituted $\varepsilon$-Fe$_2$O$_3$ magnetic crystal can be synthesized more economically advantageously by the combined process of the direct synthesis method and the sol-gel method as disclosed in Japanese Unexamined Patent Application Publication No. 2008-174405, as well as a calcination process.

In brief, by firstly adding a neutralizer such as an ammonia aqueous solution to an aqueous solvent in which a trivalent iron salt and a salt of the substitution element M (Ga, Al, etc.) are dissolved while stirring, a precursor composed of iron hydroxide (which may have been partially substituted by other elements) is formed.

Thereafter, the sol-gel method is applied thereto, thereby forming a coating layer of silica on surfaces of precursor particles. After being separated from the liquid, the silica-coated particles are subjected to heat treatment (calcination) at a predetermined temperature, thereby obtaining particulates of the M-substituted $\varepsilon$-Fe$_2$O$_3$ magnetic crystal.

In the above-described synthesis of the M-substituted $\varepsilon$-Fe$_2$O$_3$, an iron oxide crystal (impurity crystal) having a space group and an oxidized state different from those of the $\varepsilon$-Fe$_2$O$_3$ crystal may be generated. The most common examples of polymorphism, which has a composition of Fe$_3$O$_3$ with different crystal structures, include $\alpha$-Fe$_2$O$_3$ and $\gamma$-Fe$_2$O$_3$. Other iron oxides include FeO, Fe$_3$O$_4$, and the like. Presence of such impurity crystals is not preferable in terms of maximizing the characteristics of the M-substituted $\varepsilon$-Fe$_2$O$_3$ crystal, but is acceptable without interfering with the effect of the present invention.

In addition, a coercive force H$_c$ of the M-substituted $\varepsilon$-Fe$_3$O$_3$ magnetic crystal varies depending on an amount substituted by the substitution element M. In other words, by adjusting the substitution amount by the substitution element M in the M-substituted $\varepsilon$-Fe$_2$O$_3$ magnetic crystal, the coercive force H$_c$ of the M-substituted $\varepsilon$-Fe$_2$O$_3$ magnetic crystal can be adjusted. Specifically, for example, in a case in which Al, Ga, or the like is used as the substitution element M, a greater substitution amount results in a lower coercive force H$_c$ of the M-substituted $\varepsilon$-Fe$_2$O$_3$ magnetic crystal. In contrast, in a case in which Rh or the like is used as the substitution element M, a greater substitution amount results in a greater coercive force H$_c$ of the M-substituted $\varepsilon$-Fe$_2$O$_3$ magnetic crystal. Ga, Al, In, Ti, Co, and Rh are preferred as the substitution element M from the viewpoint of easy adjustment of the coercive force H$_c$ of the M-substituted $\varepsilon$-Fe$_2$O$_3$

magnetic crystal in accordance with the substitution amount by the substitution element M.

Along with the lowering of the coercive force $H_c$, a peak frequency, at which a radio wave absorption amount by the epsilon-type iron oxide is maximum, moves toward a lower frequency side or a higher frequency side. That is, a peak frequency of the radio wave absorption amount can be controlled by the substitution amount by the substitution element M.

In the case of commonly used radio wave absorbers, the absorption amount becomes almost zero if an incident angle or a frequency of a radio wave is out of a designed value. In contrast, in the case of using the epsilon-type iron oxide, even if those values are slightly out of the designed values, radio wave absorption is exhibited over a broad range of frequencies and radio wave incident angles. Given this, a radio wave absorbing layer that can absorb radio waves over a broad frequency band can be provided.

A particle size of the epsilon-type iron oxide can be controlled by, for example, adjusting the temperature of the heat treatment (calcination) in the above-described process. According to the combined process of the reverse micelle method and the sol-gel method, or the combined process of the direct synthesis method and the sol-gel method as disclosed in Japanese Unexamined Patent Application Publication No. 2008-174405, particles of epsilon-type iron oxide can be synthesized, which has a particle size within a range of 5 nm or more and 200 nm or less as an average particle size as measured from a TEM (transmission electron microscope) photograph. The average particle size of the epsilon-type iron oxide is more preferably 10 nm or more and more preferably 20 nm or more. It should be noted that, when calculating the average particle size as a number average particle size, if the particles of epsilon-type iron oxide are rod-shaped, a diameter in a longitudinal direction of the particle observed in a TEM photograph is considered to be a diameter of the particle. The number of particles to be counted for calculating the average particle size is not particularly limited as long as it is large enough to calculate an average value thereof; however, is preferably 300 or more.

In addition, the silica coated on a surface of the iron hydroxide particulate in the sol-gel method may remain on a surface of the M-substituted $\varepsilon$-Fe$_2$O$_3$ magnetic crystal after the heat treatment (calcination). Presence of a non-magnetic compound such as silica on the surface of the crystal is preferable for improving handleability, durability, weather resistance, and the like of the magnetic crystal. Preferable examples of the non-magnetic compound other than silica include heat resistant compounds such as alumina and zirconia.

However, an excessive amount of the non-magnetic compound attached may cause heavy aggregation of particles and is therefore not preferable. In a case in which the non-magnetic compound is silica, a mass of Si in the M-substituted $\varepsilon$-Fe$_2$O$_3$ magnetic crystal is preferably 100% by mass or less with respect to a total mass of the substitution element M and Fe in the M-substituted $\varepsilon$-Fe$_2$O$_3$ magnetic crystal. A part or a large part of silica attached to the M-substituted $\varepsilon$-Fe$_2$O$_3$ magnetic crystal can be removed by a method of immersion in an alkaline solution. The amount of silica to be attached can thus be adjusted to any desired amount.

Relative magnetic permeability of the composite layer is not particularly limited, but is preferably 1. 0 or more and 1.5 or less. A method of adjusting the relative magnetic permeability of a composite layer is not particularly limited. Examples of the method of adjusting the relative magnetic permeability of a composite layer include a method of adjusting a substitution amount by substitution element M in the epsilon-type iron oxide, and a method of adjusting a content of the epsilon-type iron oxide and a content of the magnetic substance other than the epsilon-type iron oxide in the composite layer, and the like.

A content of the epsilon-type iron oxide in the composite layer is not particularly limited in a range that does not inhibit the object of the present invention. The content of the magnetic substance is preferably 30% by mass or more, more preferably 40% by mass or more, particularly preferably 60% by mass or more, and most preferably 60% by mass or more and 91% by mass or less with respect to a solid content mass of the composite layer.

(Binder Resins)

The radio wave absorbing material typically includes a binder resin. By using a binder resin, the epsilon-type iron oxide or the other magnetic substance can be satisfactorily dispersed in the binder resin. When the radio wave absorbing material includes a binder resin, it is easy to form a composite layer in a desired shape.

The binder resin may be an elastic material such as an elastomer or rubber. The binder resin may be a thermoplastic resin or a curable resin. When the binder resin is a curable resin, the curable resin may be a photocurable resin or a thermosetting resin.

Suitable examples of the binder resin being a thermoplastic resin include: a polyacetal resin, a polyamide resin, a polycarbonate resin, a polyester resin (polybutylene terephthalate, polyethylene terephthalate, polyarylate, and the like), an FR-AS resin, an FR-ABS resin, an AS resin, an ABS resin, a polyphenylene oxide resin, a polyphenylene sulfide resin, a polysulfone resin, a polyethersulfone resin, a polyether ether ketone resin, a fluorine-based resin, a polyimide resin, a polyamide-imide resin, a polyamide bismaleimide resin, a polyetherimide resin, a polybenzoxazole resin, a polybenzothiazole resin, a polybenzimidazole resin, a BT resin, polymethylpentene, ultra-high molecular weight polyethylene, FR-polypropylene, a cellulose resin (e.g., methylcellulose, ethylcellulose), a (meta)acrylic resin (polymethyl methacrylate and the like), polystyrene, and the like.

Suitable examples of the binder resin being a thermosetting resin include: a phenolic resin, a melamine resin, an epoxy resin, an alkyd resin, and the like. As the photocurable resin, a resin obtained by photocuring a monomer having an unsaturated bond, such as various vinyl monomers or various (meth)acrylate esters, can be used.

Suitable examples of the binder resin being an elastic material include: an olefin-based elastomer, a styrene-based elastomer, a polyamide-based elastomer, a polyester-based elastomer, a polyurethane-based elastomer, and the like.

As the binder resin, it is preferable to use an aromatic ester-urethane copolymer. By using the aromatic ester-urethane copolymer as the biner resin, it is possible to form a film-shaped radio wave absorber having excellent radio wave absorbing characteristics, even when the radio wave absorber is thin, while the radio wave absorber satisfactorily dispersing the epsilon-type iron oxide or the other magnetic substance in the binder resin.

Furthermore, when the aromatic ester-urethane copolymer is used as the binder resin, crack resistance and low warp during bending or cutting can be imparted to the composite layer. The binder resin preferably has a glass transition temperature of 100°C or lower and more preferably 0°C or lower from the viewpoint of good crack resistance and low warp of the composite layer. Therefore, the aromatic ester-urethane copolymer also preferably has a glass transition temperature of 100°C or lower and more preferably 0°C or lower.

The aromatic ester-urethane copolymer is a copolymer having an ester bond (-CO-O-) and a urethane bond (-NH-CO-O-) and including an aromatic group in a main chain backbone thereof. The aromatic group in the main chain backbone may be an aromatic hydrocarbon group or a heterocyclic aromatic group, but is preferably an aromatic hydrocarbon group. The aromatic ester-urethane copolymer may be a random copolymer in which ester bonds and urethane bonds are randomly introduced into the molecular chain or a block copolymer composed of one or more ester blocks and one or more urethane blocks.

A method for producing the aromatic ester-urethane copolymer is not particularly limited. The aromatic ester-urethane copolymer can be typically produced by polymerizing one or more monomers selected from the group consisting of a diol component (a1), a dicarboxylic acid (a2), a hydroxycarboxylic acid component (a3), and a diisocyanate component (a4) in a one-step or multistep process.

The dicarboxylic acid component (a2) and the hydroxycarboxylic acid component (a3) may be used as an ester derivative such as methyl ester or ethyl ester; or as an ester- or urethane-forming derivative, for example, carboxylic halide such as carboxylic chloride.

The above-mentioned monomers to be used for producing the aromatic ester-urethane copolymer are preferably a compound in which two functional groups selected from the group consisting of a hydroxy group, a carboxy group, and an isocyanate group are bonded to an unbranched divalent hydrocarbon group. Examples of the unbranched divalent hydrocarbon group include an alkylene group, an alkenylene group, an alkynylene group, an arylene group, or a combination thereof. The alkylene group, the alkenylene group, and the alkynylene group are preferably in a linear structure.

When the unbranched divalent hydrocarbon group is an alkylene group, an alkenylene group, or an alkynylene group, these groups preferably have 1 or more and 8 or less carbon atoms, more preferably 2 or more and 6 or less carbon atoms, and most preferably 2 or more and 4 or less carbon atoms.

When the unbranched divalent hydrocarbon group is an arylene group, the arylene group is preferably a phenylene group and a naphthylene group, more preferably a phenylene group, and most preferably a p-phenylene group.

Among the above-mentioned unbranched divalent hydrocarbon groups, the alkylene group, the arylene group, and a combination of the alkylene group and the arylene group are preferred.

Suitable examples of the diol component (a1) include ethylene glycol, 1,3-propane diol, 1,4-butane diol, neopentyl glycol, 1,6-hexane diol, 1,4-cyclohexane dimethanol, and 1,5-pentane diol. Suitable examples of the dicarboxylic acid (a2) include terephthalic acid, isophthalic acid, 2,6-naphthalene dicarboxylic acid, 2,7-naphthalene dicarboxylic acid, 1,4-naphthalene dicarboxylic acid, 1,4-cyclohexane dicarboxylic acid, succinic acid, glutaric acid, adipic acid, oxalic acid, and malonic acid. Suitable examples of the hydroxycarboxylic acid component (a3) include 4-hydroxybenzoic acid, 3-hydroxybenzoic acid, 6-hydroxynaphthalene-2-carboxylic acid, glycolic acid, lactic acid, and γ-hydroxybutyric acid. Suitable examples of the diisocyanate component (a4) include ethylene diisocyanate, trimethylene diisocyanate, tetramethylene diisocyanate, hexamethylene diisocyanate, isophorone diisocyanate, m-xylylene diisocyanate, p-phenylene diisocyanate, tolylene diisocyanate, 4,4'-diphenylmethane diisocyanate, and 1,5-naphthalene diisocyanate.

The aromatic ester-urethane copolymer preferably has a weight average molecular weight (Mw) of 5000 or more and 500000 or less and more preferably 10000 or more and 200000 or less. In the present specification, the weight average molecular weight (Mw) refers to a weight average molecular weight in terms of polystyrene as measured by gel permeation chromatography (GPC).

Examples of commercially available products of the aromatic ester-urethane copolymer include VYLON series (product name) (manufactured by TOYOBO CO., LTD.). More specifically, VYLON UR-1400, VYLON UR-1410, VYLON UR-1700, VYLON UR-2300, VYLON UR-3200, VYLON UR-3210, VYLON UR-3500, VYLON UR-6100, VYLON UR-8300, and VYLON UR-8700 can be preferably used.

A content of the binder resin in the radio wave absorbing material is not particularly limited in a range that does not inhibit the object of the present invention. The radio wave absorbing material contains the binder resin in a content of preferably 5% by mass or more and 30% by mass or less, and more preferably in a content of 5% by mass or more and 25% by mass or less with respect to the solid content of the composite layer.

(Dielectrics)

The radio wave absorbing material may include a dielectric in order to adjust the relative permittivity of the composite layer. The relative permittivity of the composite layer may be adjusted by adjusting the content of the dielectric in the composite layer. Relative permittivity of the radio wave absorbing layer is not particularly limited, but is preferably 6.5 or more and 65 or less, more preferably 10 or more and 50 or less, and further preferably 15 or more and 30 or less.

Preferred examples of the dielectric include barium titanate, strontium titanate, calcium titanate, magnesium titanate, bismuth titanate, zirconium titanate, zinc titanate, and titanium dioxide. The radio wave absorbing material can include a combination of multiple types of dielectric powder.

A particle size of the dielectric powder used for adjusting the relative permittivity of the composite layer is not particularly limited without interfering with the objective of the present invention. An average particle size of the dielectric powder is preferably 1 nm or more and 100 nm or less, and more preferably 5 nm or more and 50 nm or less. The average particle size of the dielectric powder is a number average particle size of primary particles of the dielectric powder observed by an electron microscope.

In a case of adjusting the relative permittivity of the radio wave absorbing layer using the dielectric powder, an amount of the dielectric powder to be used is not particularly limited as long as the relative permittivity of the radio wave absorbing layer is within a predetermined range. An amount of the dielectric powder to be used is preferably 0% by mass or more and 20% by mass or less and more preferably 5% by mass or more and 10% by mass or less with respect to a solid content mass of each of the radio wave absorbing layer.

(Carbon Nanotube)

By adding a carbon nanotube to the radio wave absorbing layer, the relative permittivity can be adjusted. The carbon nanotube may be used together with the above-mentioned dielectric powder.

The blending amount of the carbon nanotubes in the radio wave absorbing material is not particularly limited as long as the relative permittivity of the composite layer is within the above-mentioned predetermined range. However, since the carbon nanotube is also a conductive material, an excessive amount of the carbon nanotube may deteriorate a radio wave absorbing property provided by the radio wave absorbing layer. An amount of the carbon nanotube to be used is preferably 0% by mass or more and 20% by mass or less and more preferably 1% by mass or more and 10% by mass or less with respect to a solid content mass of the radio wave absorbing layer.

[Thermally Conductive Materials]

The thermally conductive material is not particularly limited as long as the thermally conductive material is recognized by those skilled in the art as a material having high thermal conductivity. For example, the thermal conductivity of the thermally conductive material is preferably 15 W/m·K or more, more preferably 20 W/m·K or more, more preferably 50 W/m·K or more, and most preferably 200 W/m·K or more.

Examples of the material exhibiting a thermal conductivity of 15 W/m-K or more include alumina, aluminum nitride, silicon carbide, and boron nitride. These thermally conductive materials may be used in combination of two or more types thereof. Among them, alumina and silicon carbide are preferable because they are easy to obtain, and a radio wave absorber excellent in heat dissipation and radio wave absorption properties can be easily obtained.

The shape of the thermally conductive material is not particularly limited as long as the object of the present invention is not inhibited. The thermally conductive material is preferably granular or scale-shaped powder. The thermally conductive material having such a shape has a small aspect ratio and is difficult to be oriented in the composite layer. Therefore, when a thermally conductive material, which is granular or scale-shaped powder, is used, bending, cracking, tearing, or the like of the composite layer due to the orientation of the thermally conductive material is likely to be suppressed. The aspect ratio (average major axis length/average minor axis length) of the thermally conductive material is preferably less than 6, more preferably 5 or less, and most preferably 3 or less. The average long-axis length and the average short-axis length of the thermally conductive material can be determined as a number average length by, for example, a microscope observation or a SEM observation. Further, by using a combination of a granular thermally conductive material and a scale-shaped thermally conductive material, it is easy to increase thermal diffusivity of the radio wave absorber. In particular, when granular alumina and scale-shaped boron nitride are used in combination, not only the thermal diffusivity but also the thermal conductivity tends to be significantly increased. When the granular thermally conductive material and the scale-shaped thermally conductive material are used in combination, the ratio of the mass of the scale-shaped thermally conductive material with respect to a total of the mass of the granular thermally conductive material and the mass of the scale-shaped thermally conductive material is preferably 7% by mass or more and 50% by mass or less, more preferably 10% by mass or more and 50% by mass or less, and most preferably 15% by mass or more and 40% by mass or less from the viewpoint of improvement effects in the thermal conductivity and film-forming property of the radio wave absorber forming paste.

The above-mentioned granular or scale-shaped powder thermally conductive material is preferably dispersed in the above-described matrix formed of the radio wave absorbing material from the viewpoint of good heat dissipation of the radio wave absorber.

The amount of the thermally conductive material used is not particularly limited, and is appropriately adjusted in accordance with a desired level of heat dissipation performance of the radio wave absorber. Typically, it is preferable to use the thermally conductive material such that the composite layer contains the thermally conductive material in a content of preferably 30 parts by mass or more and 300 parts by mass or less, and more preferably 40 parts by mass or more and 200 parts by mass or less, with respect to 100 parts by mass of the radio wave absorbing material.

(Other Components)

The composite layer may include various additives other than the above-mentioned components without interfering with the objective of the present invention. Examples of the additives that may be included in the composite layer include a dispersant, a coloring agent, an antioxidant, a UV absorber, a fire retardant, a fire retardant aid, a plasticizer, a surfactant, and the like. These additives are used without interfering with the objective of the present invention, taking into consideration conventionally used amounts thereof.

By simultaneously performing film formation of the radio wave absorbing material, the thermally conductive material, and, if necessary, other components, and complex layer formation, using, for example, a radio wave absorber forming paste (described below), a composite layer which can be used as a radio wave absorber capable of achieving both good radio wave absorption characteristics in a high frequency band and good heat dissipation characteristics can be obtained.

<Substrate layer>

The composite layer may be laminated on a substrate layer. The substrate layer may be a layer including any substrate without impairing the effect of the present invention, and examples thereof include layers including a resin. Examples of the above-mentioned resin include polyethylene terephthalate (PET), polyethylene naphthalate (PEN), acrylic (PMMA), polycarbonate (PC), a cycloolefin polymer (COP), polyether sulfone, polyimide, polyamide-imide, and the like. Among them, PET is preferable because of excellent heat resistance and well-balanced dimension stability and cost.

The substrate layer may have a curved surface or be only composed of a planar surface, and is preferably a flat plate shape. A thickness of the substrate layer is preferably 800 um or less, more preferably 500 um or less, further preferably 300 um or less, and particularly preferably 150 um or less from the viewpoint of thinning or downsizing of the film without impairing the effect of the present invention. The lower limit of the thickness of the substrate layers is not particularly limited without impairing the effect of the present invention, but, for example, 1 um or more, 10 um or more, 50 um or more, or the like.

<Metal layer>

When the radio wave absorber includes a substrate layer, the radio wave absorber may include a metal layer on a surface opposite to the surface of the substrate layer on which the composite layer is formed. When the metal layer is disposed, radio waves reflected by the metal layer can be attenuated. As metal constituting the metal layer, for example, aluminum, titanium, SUS, copper, brass, silver, gold, and platinum are preferred. A thickness of the metal layer is not particularly limited, but is preferably 600 um or less, more preferably 400 um or less, further preferably 100 um or less, and particularly preferably 50um or less from the viewpoint of thinning the radio wave absorber. The lower limit of the thickness of the metal layer is not particularly limited without impairing the effect of the present invention, but is, for example, 0.1 um or more, 1 um or more, 5 um or more, 10 um or more, or the like.

By combining the above-described composite layer containing a predetermined component with the substrate layer or with the substrate layer and the metal layer as necessary, a radio wave absorber capable of achieving both good radio wave absorption characteristics in a high frequency band and good heat dissipation properties can be obtained.

The above-described radio wave absorber can be preferably used as a radio wave absorbing film to be used for a variety of elements (including automotive elements, high-frequency antenna elements, etc.) in various information communication systems such as cellular telephones, wireless LANs, ETC systems, intelligent transport systems, driving support road systems, satellite broadcasting, and the like

<<Radio wave absorber forming paste>>

As a method of forming the radio wave absorber, a method using a radio wave absorber forming paste is preferable because the composite layer can be formed with high efficiency without particular limitation in thickness, and the composite layer can be formed directly on a substrate layer. The radio wave absorber forming paste includes the above-described radio wave absorbing material and the thermally conductive material. The radio wave absorber forming paste preferably further contains a binder resin. The radio wave absorber forming paste may contain a substance added for adjusting the relative permittivity, relative magnetic permeability, and the like of the above-described radio wave absorbing material, other components, and the like. When the binder resin contains a curable resin, the radio wave absorber forming paste contains a compound which serves as a precursor of the curable resin. In this case, the radio wave absorber forming paste contains a curing agent, a curing accelerator, a polymerization initiator, and the like as necessary.

When the radio wave absorber forming paste contains a photopolymerizable or thermally polymerizable compound, a coating film may be exposed or heated as necessary to form the composite layer.

The radio wave absorber forming paste preferably further includes a dispersion medium. As the dispersion medium, water, an organic solvent, and an aqueous solution of an organic solvent can be used. As the dispersion medium, an organic solvent is preferable, since the organic solvent can easily dissolve organic components and has low latent heat of vaporization, allowing easy removal by drying.

Preferred examples of the organic solvent to be used as the dispersion medium include: nitrogen-containing polar solvents such as N,N,N',N'-tetramethylurea (TMU), N-methyl-2-pyrrolidone (NMP), N,N-dimethylacetamide (DMAc), N,N-dimethylisobutylamide, N,N-diethylacetamide, N,N-dimethylformamide (DMF), N,N-diethylformamide, N-methylcaprolactam, 1,3-dimethyl-2-imidazolidinone (DMI), and pyridine; ketones such as diethyl ketone, methyl butyl ketone, dipropyl ketone, and cyclohexanone; alcohols such as n-pentanol, 4-methyl-2-pentanol, cyclohexanol, and diacetone alcohol; ether-based alcohols such as ethylene glycol monomethyl ether, ethylene glycol monoethyl ether, ethylene glycol monobutyl ether, propylene glycol monomethyl ether, propylene glycol monoethyl ether, diethylene glycol monomethyl ether, diethylene glycol monoethyl ether, diethylene glycol dimethyl ether, and diethylene glycol diethyl ether; alkyl esters of saturated aliphatic monocarboxylic acid such as n-butyl acetate and amyl acetate; lactate esters such as ethyl lactate and n-butyl lactate; ketones such as acetone, methyl ethyl ketone, cyclohexanone, acetophenone, and benzophenone; and ether-based esters such as methylcellosolve acetate, ethylcellosolve acetate, propylene glycol monomethyl ether acetate, propylene glycol monoethyl ether acetate, ethyl-3-ethoxypropionate, 2-methoxybutyl acetate, 3-methoxybutyl acetate, 4-methoxybutyl acetate, 2-methyl-3-methoxybutyl acetate, 3-methyl-3-methoxybutyl acetate, 3-ethyl-3-methoxybutyl acetate, 2-ethoxybutyl acetate, 4-ethoxybutyl acetate, 4-propoxybutyl acetate, and 2-methoxypentyl acetate. These may be used singly or in combination of two or more.

A solid content concentration of the radio wave absorber forming paste is appropriately adjusted dependent upon the method of applying the radio wave absorber forming paste, the thickness of the composite layer, or the like. Typically, the solid content concentration of the radio wave absorber forming paste is preferably 3% by mass or more and 60% by mass or less, and more preferably 10% by mass or more and 50% by mass or less. Note that a solid content concentration of a paste is a value calculated by regarding a total of a mass of a component not dissolved in the dispersion medium and a mass of a component dissolved in the dispersion medium is the mass of the solid content.

(Dispersant)

In order to favorably disperse, in the composite layer, the epsilon-type iron oxide or substances to be added for adjusting the relative permittivity and the relative magnetic permeability of the composite layer, the radio wave absorber forming paste may include a dispersant. The dispersant can be blended uniformly along with the above-mentioned epsilon-type iron oxide, the binder resin, and the like. The dispersant may be incorporated in the binder resin. Furthermore, the epsilon-type iron oxide or substances to be added for adjusting the relative permittivity and the relative magnetic permeability may be treated with the dispersant in advance and then added to a material to constitute the composite layer.

The type of dispersant is not particularly limited in a range that does not inhibit the object of the present invention. The dispersant can be selected from various dispersants conventionally used for dispersing various inorganic particulates and organic particulates.

Preferred examples of the dispersant include a silane coupling agent (e.g., phenyltrimethoxysilane), a titanate coupling agent, a zirconate coupling agent, an aluminate coupling agent, and the like.

A content of dispersant is not particularly limited in a range that does not inhibit the object of the present invention. The content of dispersant is preferably 0.1% by mass or more and 30% by mass or less, more preferably 1% by mass or more and 15% by mass or less, and most preferably 1% by mass or more and 10% by mass or less, with respect to a mass of a solid content of the radio wave absorber forming paste.

<<Method for producing radio wave absorber>>

A method for producing the above-mentioned radio wave absorber is not particularly limited as long as a radio wave absorber having a predetermined configuration can be produced. As a preferable method, there is a method including a composite layer forming step in which a coating film is formed by applying the above-described paste containing a radio wave absorbing material and a thermally conductive material on a substrate layer, and then drying the coating film to form a composite layer.

A method for applying the radio wave absorber forming paste onto the substrate layer is not particularly limited as long as a radio wave absorber having a desired thickness can be formed. Examples of the application method include a spray coating method, a dip coating method, a roll coating method, a curtain coating method, a spin coating method, a screen printing method, a doctor blade method, and an applicator method, and the like. An applied film formed by the above-mentioned method may be dried to remove a dispersion medium, thereby forming the composite layer. Thus, the radio wave absorber is obtained. A thickness of the applied film is appropriately adjusted so that a thickness of the thus-dried composite film is a desired thickness. A drying method is not particularly limited, and examples thereof include (1) a method of drying the film on a hot plate at a temperature of 80°C or more and 180°C or less and preferably 90°C or more and 160°C or less for 1 minute or more and 30 minutes or less, (2) a method of leaving to stand the film at room temperature for several hours to several days, (3) a method of placing the film in a warm air heater or an infrared heater for several tens of minutes to several hours, thereby removing a solvent, and the like.

The method for producing the radio wave absorber may include a cutting step in which a laminate that includes the composite layer or the substrate layer and the composite layer and that obtained from the composite layer forming step is cut to thereby obtain a radio wave absorber having a predetermined size. As described above, since the radio wave absorber includes the composite layer formed of the radio wave absorbing material and the thermally conductive material, good radio wave absorption characteristics in the high-frequency band and good heat dissipation can be achieved at the same time.

EXAMPLES

Hereinafter, the present invention will be described in more detail based on Examples, but is not limited thereto.

[Example 1]

(Preparation of Radio Wave Absorber Forming Paste)

To 25.1 parts by mass of TMU as the dispersion medium, 39 parts by mass of the following epsilon-type iron oxide as the radio wave absorbing material, 2.4 parts by mass of the following carbon nanotube (CNT), 8.6 parts by mass of a binder resin, and 21.4 parts by mass of granular alumina powder as the thermally conductive material were added. The binder resin was added as a binder resin solution shown below. The resultant was stirred by a rotating and revolving mixer to uniformly dissolve or disperse the above-mentioned components. Thus, a radio wave absorber forming paste was obtained.

As the epsilon-type iron oxide, $\varepsilon$-$Ga_{0.45}Fe_{1.55}O_3$ was used. The epsilon-type iron oxide had an average particle size of 20 nm or more and 30 nm or less. As the CNT, a multilayered carbon nanotube having a major axis of 150 nm (commercial name: VGCF-H; manufactured by Showa Denko K.K.) was used. As the dispersant, phenyltrimethoxysilane was used. As the binder resin solution, an aromatic ester-urethane copolymer (manufactured by TOYOBO CO., LTD., VYLON UR-3210, glass transition temperature: -3°C, weight average molecular weight: 40000, composed of 5 parts by mass of a resin and 15 parts by mass of methyl ethyl ketone) was used.

(Production of radio wave absorber film)

A PET film (thickness: 125 um) was coated with the above-mentioned radio wave absorber forming paste using an applicator. Then, the resultant coating film was dried at 90°C for 10 minutes and at 130°C for 10 minutes to thereby form a composite layer having a thickness of 35 um. Thus, a film-shaped radio wave absorber was obtained. Immediately after the drying, the resultant film-shaped radio wave absorber was cut to a square of 5 cm x 5 cm. Thus, a test piece for the belowmentioned evaluation was produced.

<Reflection Loss>

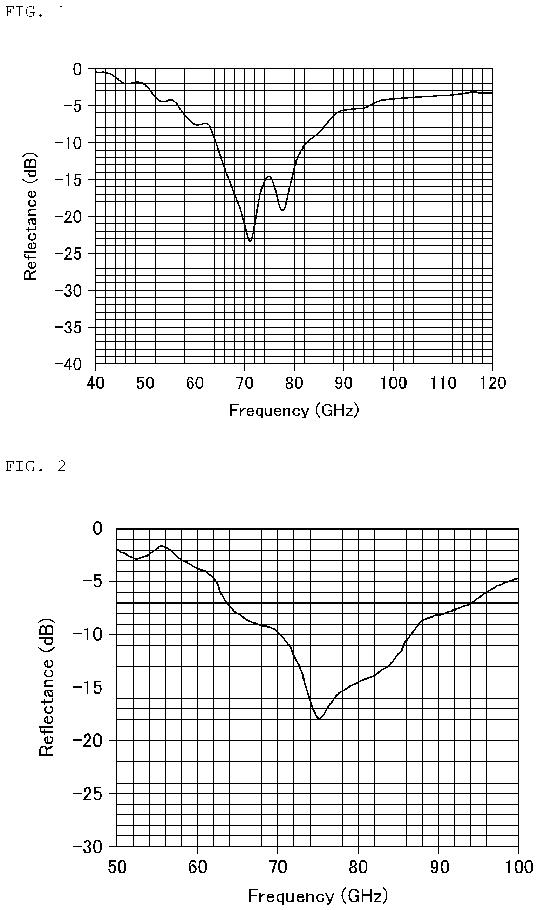

A sample of a film-shaped radio wave absorber cut into a square of 5 cm x 5 cm was adhered onto an aluminum plate. Radio waves of 40 to 120 GHz were allowed to be incident on the sample for measurement on the aluminum plate and reflection loss thereof was measured using Terahertz Spectroscopic System (manufactured by Advantest Corporation). Reflection loss RL (f) at a frequency f was obtained by RL (f) = -10 Log (R(f)/100). Herein, R (f) represents reflectance (%). Reflection loss (reflectance (dB)) of the film-shaped radio wave absorber of Example 1 in a frequency of 40 to 120 GHz is shown in FIG. 1.

<Thermal Conductivity and Thermal Diffusivity>

The thermal conductivity and thermal diffusivity of the obtained film-shaped radio wave absorber were measured by the following method. The results of these measurements are shown in Table 1. The thermal diffusivity was measured by a periodical heating method. Specifically, the thermal diffusivity was measured using a periodical heating thermal diffusivity measurement apparatus (FTC-1) manufactured by ULVAC-RIKO. The thermal conductivity $\lambda$ was calculated from the following equation based on the thermal diffusivity $\alpha$ measured by the above method. Note that the specific heat capacity $C\rho$ applied to the following equation was measured by DSC method at a measurement temperature of 25°C using X-DSC 7000 manufactured by Hitachi High-Tech Science.

$$\lambda = \alpha \times C\rho \times \rho \times 100$$

$\lambda$: Thermal conductivity (W/(m-K))
$\alpha$: Thermal diffusivity (cm$^2$/s)
$C\rho$: Specific heat (J/(g-K))
$\rho$: Density (g/cm$^3$)

[Example 2]

A film-shaped radio wave absorber was obtained in the same manner as in Example 1 except that the amount of TMU added was changed to 35 parts by mass and the amount of granular alumina powder used was changed to 50 parts by mass. The thermal conductivity and thermal diffusivity of the obtained film-shaped radio wave absorber were measured in the same manner as in Example 1. The results of these measurements are shown in Table 1.

[Example 3]

To 35 parts by mass of TMU as the dispersion medium, 29.5 parts by mass of epsilon-type iron oxide as the radio wave absorbing material, 2.5 parts by mass of carbon nanotubes (CNT), 13 parts by mass of the binder resin, and 55 parts by mass of granular alumina powder as the thermally conductive material were added. The binder resin was added as a binder resin solution shown below. The resultant was stirred by a rotating and revolving mixer to uniformly dissolve or disperse the above-mentioned components. Thus, a radio wave absorber forming paste was obtained. Using the obtained radio wave absorber forming paste, a film-shaped radio wave absorber was obtained in the same manner as in Example 1. With respect to the obtained film-shaped radio wave absorber, the reflection loss (reflectance (dB)) in the frequency range of 40 to 120 GHz was measured in the same manner as in Example 1. The measurement results are shown in FIG. 2. The thermal conductivity and thermal diffusivity of the obtained film-shaped radio wave absorber were measured in the same manner as in Example 1. The results of these measurements are shown in Table 1.

[Example 4]

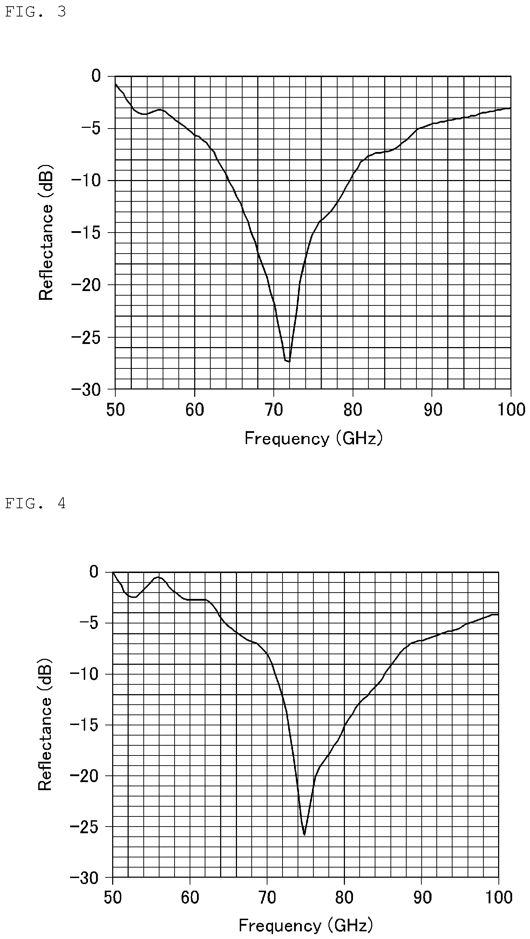

A film-shaped radio wave absorber was obtained in the same manner as in Example 3, except that 55 parts by mass of granular alumina powder was changed to 50 parts by mass of granular alumina powder and 5 parts by mass of scale-shaped boron nitride powder. With respect to the obtained film-shaped radio wave absorber, the reflection loss (reflectance (dB)) in the frequency range of 40 to 120 GHz was measured in the same manner as in Example 1. The measurement results are shown in FIG. 3. The thermal conductivity and thermal diffusivity of the obtained film-shaped radio wave absorber were measured in the same manner as in Example 1. The results of these measurements are shown in Table 1.

[Example 5]

A film-shaped radio wave absorber was obtained in the same manner as in Example 3, except that 55 parts by mass of granular alumina powder was changed to 45 parts by mass of granular alumina powder and 10 parts by mass of scale-shaped boron nitride powder. With respect to the obtained film-shaped radio wave absorber, the reflection loss (reflectance (dB)) in the frequency range of 40 to 120 GHz was measured in the same manner as in Example 1. The measurement results are shown in FIG. 4. The thermal conductivity and thermal diffusivity of the obtained film-shaped radio wave absorber were measured in the same manner as in Example 1. The results of these measurements are shown in Table 1.

[Example 6]

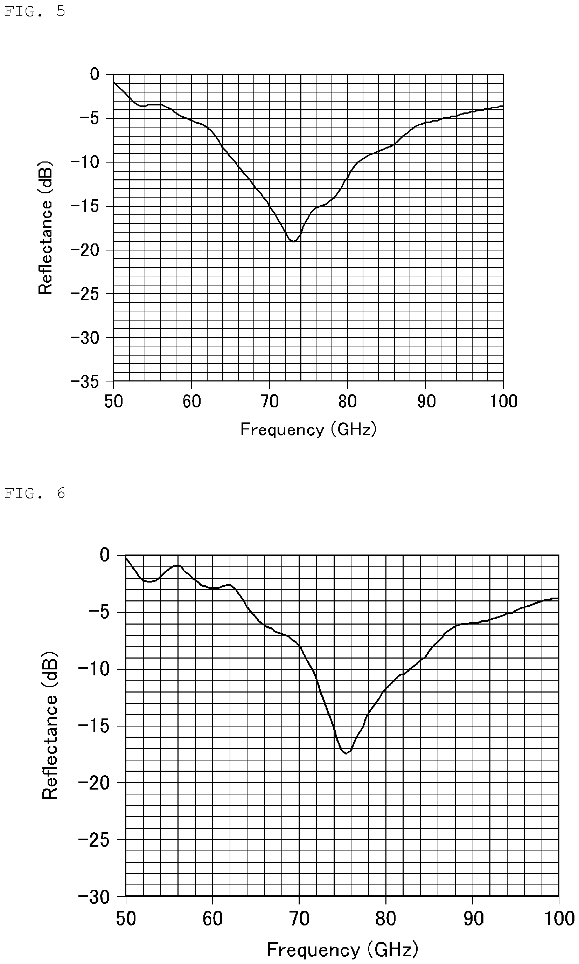

A film-shaped radio wave absorber was obtained in the same manner as in Example 3, except that 55 parts by mass of granular alumina powder was changed to 40 parts by mass of granular alumina powder and 15 parts by mass of scale-shaped boron nitride powder. With respect to the obtained film-shaped radio wave absorber, the reflection loss (reflectance (dB)) in the frequency range of 40 to 120 GHz was measured in the same manner as in Example 1. The measurement results are shown in FIG. 5. The thermal conductivity and thermal diffusivity of the obtained film-shaped radio wave absorber were measured in the same manner as in Example 1. The results of these measurements are shown in Table 1.

[Example 7]

A film-shaped radio wave absorber was obtained in the same manner as in Example 3, except that 55 parts by mass of granular alumina powder was changed to 35 parts by mass of granular alumina powder and 20 parts by mass of scale-shaped boron nitride powder. With respect to the obtained film-shaped radio wave absorber, the reflection loss (reflectance (dB)) in the frequency range of 40 to 120 GHz was measured in the same manner as in Example 1. The measurement results are shown in FIG. 6. The thermal conductivity and thermal diffusivity of the obtained film-shaped radio wave absorber were measured in the same manner as in Example 1. The results of these measurements are shown in Table 1.

[Example 8]

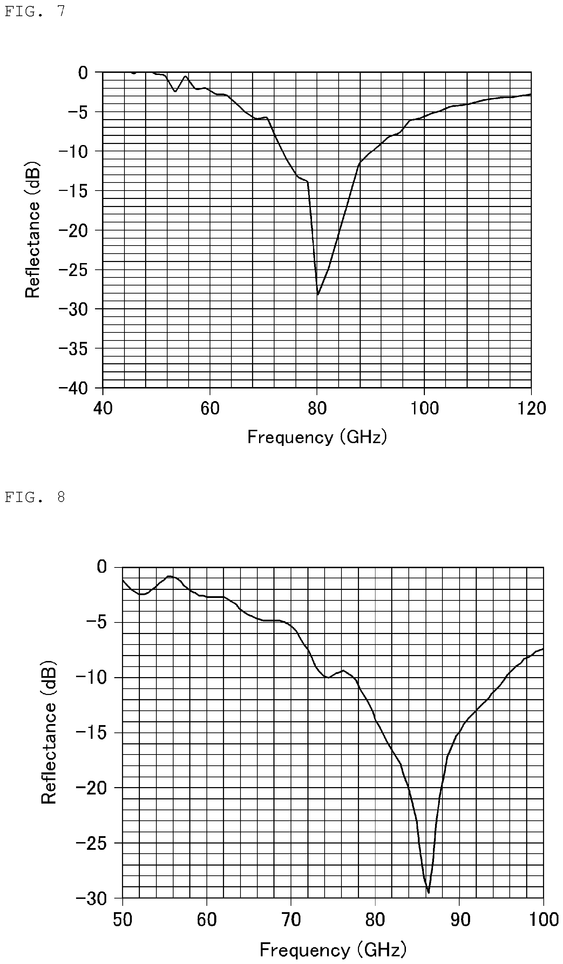

A film-shaped radio wave absorber was obtained in the same manner as in Example 2, except that the granular alumina powder was changed to granular silicon carbide powder. With respect to the obtained film-shaped radio wave absorber, the reflection loss (reflectance (dB)) in the frequency range of 40 to 120 GHz was measured in the same manner as in Example 1. The measurement results are shown in FIG. 7. The thermal conductivity and thermal diffusivity of the obtained film-shaped radio wave absorber were measured in the same manner as in Example 1. The results of these measurements are shown in Table 1.

[Example 9]

A film-shaped radio wave absorber was obtained in the same manner as in Example 2, except that 50 parts by mass of granular alumina powder was changed to 40 parts by mass of granular silicon carbide powder and 10 parts by mass of scale-shaped boron nitride powder. With respect to the obtained film-shaped radio wave absorber, the reflection loss (reflectance (dB)) in the frequency range of 40 to 120 GHz was measured in the same manner as in Example 1. The measurement results are shown in FIG. 8. The thermal conductivity and thermal diffusivity of the obtained film-shaped radio wave absorber were measured in the same manner as in Example 1. The results of these measurements are shown in Table 1.

[Example 10]

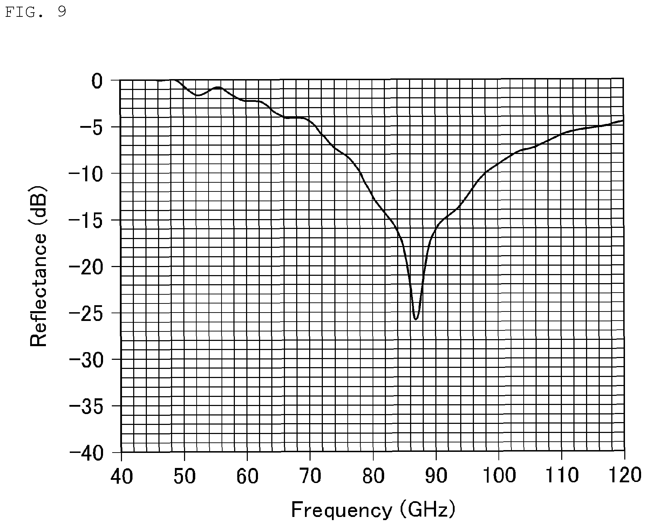

A film-shaped radio wave absorber was obtained in the same manner as in Example 2, except that the granular alumina powder was changed to the scale-shaped boron nitride powder. With respect to the obtained film-shaped radio wave absorber, the reflection loss (reflectance (dB)) in the frequency range of 40 to 120 GHz was measured in the same manner as in Example 1. The measurement results are shown in FIG. 9. The thermal conductivity and thermal diffusivity of the obtained film-shaped radio wave absorber were measured in the same manner as in Example 1. The results of these measurements are shown in Table 1.

[Comparative Example 1]

A film-shaped radio wave absorber was obtained in the same manner as in Example 1 except that powdery alumina was not used. The thermal conductivity and thermal diffusivity of the obtained film-shaped radio wave absorber were measured in the same manner as in Example 1. The results of these measurements are shown in Table 1.

[Table 1]

| | Thermally conductive material | | Thermal diffusivity $\times$ $e^{-10}$ (m²/s) | Thermal conductivity (W/(m·K)) |
|---|---|---|---|---|
| | Type | Ratio of mass of thermally conductive material to mass of radio wave absorbing material (% by mass) | | |
| Example 1 | Alumina | 42.9 | 7.28 | 1.65 |
| Example 2 | Alumina | 100 | 9.20 | 2.52 |
| Example 3 | Alumina | 122.2 | 8.90 | 2.50 |
| Example 4 | Alumina | 111.1 | 10.50 | 2.66 |
| | Boron nitride | 11.1 | | |
| Example 5 | Alumina | 100 | 15.60 | 3.95 |
| | Boron nitride | 22.2 | | |
| Example 6 | Alumina | 88.9 | 20.40 | 3.92 |
| | Boron nitride | 33.3 | | |
| Example 7 | Alumina | 77.8 | 23.50 | 3.91 |
| | Boron nitride | 44.4 | | |
| Example 8 | Silicon carbide | 100 | 21.00 | 4.62 |
| Example 9 | Silicon carbide | 80 | 22.50 | 4.35 |
| | Boron nitride | 20 | | |
| Example 10 | Boron nitride | 100 | 16.50 | 3.20 |
| Comparative Example 1 | - | 0 | 4.05 | 1.15 |

According to Table 1 and FIGs. 1 to 9, it is understood that the radio wave absorbers of Examples 1 to 10, which comprise a composite layer including a radio wave absorbing material and a thermally conductive material, the radio wave absorbing material containing a predetermined epsilon type iron oxide, could achieve both good radio wave absorption characteristics in a high frequency band and good heat dissipation characteristics. On the other hand, it is understood from Comparative Example 1 that when the radio wave absorbing material does not contain a thermally conductive material, the thermal diffusivity and thermal conductivity of the radio wave absorber were low. Further, according to comparison between Example 8 and Example 9, and comparison between Examples 2 to 3 and Examples 4 to 7, it is understood that when a combination of a granular thermally conductive material and a scale-shaped thermally conductive material was used, the thermal diffusivity was higher than when only a granular thermally conductive material was used. In particular, it can be understood from the comparison between Examples 2 to 3 and Examples 4 to 7 that the thermal diffusivity and thermal conductivity could be significantly increased by using a combination of granular alumina powder and scale-shaped boron nitride powder as compared with the case of using only granular alumina powder.

**Claims**

1. A radio wave absorber comprising a composite layer,

   the composite layer comprising: a radio wave absorbing material and a thermally conductive material,
   the radio wave absorbing material comprising epsilon-type iron oxide,
   the epsilon-type iron oxide being at least one selected from the group consisting of an $\varepsilon$-$Fe_2O_3$ crystal and a crystal represented by formula $\varepsilon$-$M_xFe_{2-x}O_3$, in which x is greater than 0 and less than 2, the crystal represented by $\varepsilon$-$M_xFe_{2-x}O_3$ having an identical crystal structure and space group to those of the $\varepsilon$-$Fe_2O_3$ crystal, some of Fe sites thereof being substituted with an elemental M other than Fe.

2. The radio wave absorber according to claim 1, wherein the radio wave absorbing material comprises a carbon nanotube.

3. The radio wave absorber according to claim 1 or 2, wherein the radio wave absorbing material comprises a binder resin.

4. The radio wave absorber according to claim 3, wherein the epsilon-type iron oxide or the epsilon-type iron oxide and the carbon nanotube are dispersed in the binder resin.

5. The radio wave absorber according to claim 3 or 4,

   wherein the thermally conductive material is granular and/or
   scale-shaped powder, and
   the thermally conductive material is dispersed in a matrix formed of the radio wave absorbing material.

6. The radio wave absorber according to any one of claims 1 to 5, wherein the thermally conductive material comprises at least one selected from the group consisting of alumina, silicon carbide, and boron nitride.

7. The radio wave absorber according to claim 5, wherein the thermally conductive material comprises a combination of a granular thermally conductive material and a scale-shaped thermally conductive material.

8. The radio wave absorber according to any one of claims 5 to 7, wherein the thermally conductive material comprises a combination of granular alumina and scale-shaped boron nitride.

9. The radio wave absorber according to any one of claims 1 to 8, wherein the composite layer comprises the thermally conductive material in a content of 30 parts by mass or more and 300 parts by mass or less, with respect to 100 parts by mass of the radio wave absorbing material.

10. The radio wave absorber according to any one of claims 1 to 9, wherein the radio wave absorber is in a film shape.

11. A radio wave absorber forming paste,

   comprising a radio wave absorbing material and a thermally conductive material,
   the radio wave absorbing material comprising epsilon-type iron oxide,
   the epsilon-type iron oxide being at least one selected from the group consisting of an $\varepsilon$-$Fe_2O_3$ crystal and a crystal represented by formula $\varepsilon$-$M_xFe_{2-x}O_3$, in which x is greater than 0 and less than 2, the crystal represented by $\varepsilon$-$M_xFe_{2-x}O_3$ having an identical crystal structure and space group to those of the $\varepsilon$-$Fe_2O_3$ crystal, some of Fe sites thereof being substituted with an elemental M other than Fe.

FIG. 1

FIG. 2

FIG. 3

FIG. 4

FIG. 5

FIG. 6

FIG. 7

FIG. 8

FIG. 9

## INTERNATIONAL SEARCH REPORT

| International application No. |
| --- |
| PCT/JP2021/018230 |

A. CLASSIFICATION OF SUBJECT MATTER
H05K 9/00(2006.01)i; C01G 49/00(2006.01)i; C01G 49/06(2006.01)i; H01F 1/28(2006.01)i
FI: H05K9/00 M; H01F1/28; C01G49/06 Z; C01G49/00 A
According to International Patent Classification (IPC) or to both national classification and IPC

B. FIELDS SEARCHED

Minimum documentation searched (classification system followed by classification symbols)
H05K9/00; C01G49/00; C01G49/06; H01F1/28

Documentation searched other than minimum documentation to the extent that such documents are included in the fields searched
| | |
| --- | --- |
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2016-111341 A (THE UNIVERSITY OF TOKYO) 20 June 2016 (2016-06-20) claims 1, 3, 5, paragraphs [0013]-[0025], [0056]-[0057], [0086]-[0088] | 1-11 |
| Y | WO 2019/017471 A1 (MAXELL HOLDINGS, LTD.) 24 January 2019 (2019-01-24) paragraphs [0031]-[0045], [0077] | 1-11 |
| Y | JP 2008-277726 A (THE UNIVERSITY OF TOKYO) 13 November 2008 (2008-11-13) paragraph [0034] | 1-11 |
| Y | JP 2002-026204 A (KITAGAWA INDUSTRIES CO., LTD.) 25 January 2002 (2002-01-25) paragraphs [0021]-[0024] | 5-10 |
| Y | WO 2018/147228 A1 (DEXERIALS CORPORATION) 16 August 2018 (2018-08-16) paragraphs [0030]-[0031] | 5-10 |

☐ Further documents are listed in the continuation of Box C.    ☒ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 09 July 2021 (09.07.2021) | 20 July 2021 (20.07.2021) |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**
Information on patent family members

| International application no. |
| --- |
| PCT/JP2021/018230 |

| Patent Documents referred in the Report | Publication Date | Patent Family | Publication Date |
| --- | --- | --- | --- |
| JP 2016-111341 A | 20 Jun. 2016 | US 2016/0164187 A1 claims 1, 3, 5, paragraphs [0021]-[0037], [0077]-[0079], [0111]-[0116] EP 3029771 A1 KR 10-2016-0067051 A | |
| WO 2019/017471 A1 | 24 Jan. 2019 | US 2020/0227833 A1 paragraphs [0031]-[0045], [0094] EP 3657922 A1 CN 110915317 A TW 201908390 A | |
| JP 2008-277726 A | 13 Nov. 2008 | US 2010/0238063 A1 paragraph [0061] EP 2058824 A1 CN 101512686 A | |
| JP 2002-026204 A | 25 Jan. 2002 | (Family: none) | |
| WO 2018/147228 A1 | 16 Aug. 2018 | JP 2018-129443 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009060060 A
- JP 2008277726 A
- JP 2008174405 A

**Non-patent literature cited in the description**

- **A.NAMAI ; S.SAKURAI ; M.NAKAJIMA ; T.SUEMOTO ; K.MATSUMOTO ; M.GOTO ; S.SA SAKI ; S.OHKOSHI.** *J.Am.Chem.Soc.,* 2009, vol. 131, 1170-1173
- **A.NAMAI ; M.YOSHIKIYO ; K.YAMADA ; S.SAKURAI ; T.GOTO ; T.YOSHIDA ; T.MIYA ZAKI ; M.NAKAJIMA ; T.SUEMOTO ; H.TOKORO.** *Nature Communications,* 2012, vol. 3 (1035), 1-6
- **S.OHKOSHI ; S.KUROKI ; S.SAKURAI ; K.MATSUMOTO ; K.SATO ; S.SASAKI.** *Angew.Chem.Int.Ed.,* 2007, vol. 46, 8392-8395
- **A.NAMAI ; K.OGATA ; M.YOSHIKIYO ; S.OHKO-SHI.** *Bull.Chem.Soc.Jpn.,* 2020, vol. 93, 20-25
- **JIAN JIN ; SHINICHI OHKOSHI ; KAZUHITO HASHIMOTO.** *ADVANCED MATERIALS,* 05 January 2004, vol. 16 (1), 48-51
- **SHIN-ICHI OHKOSHI ; SHUNSUKE SAKURAI ; JIAN JIN ; KAZUHITO HASHIMOTO.** *JOURNAL OF APPLIED PHYSICS,* 2005, vol. 97, 10K312
- **SHUNSUKE SAKURAI ; JIAN JIN ; KAZUHITO HASHIMOTO ; SHINICHI OHKOSHI.** *JOURNAL OF THE PHYSICAL SOCIETY OF JAPAN,* July 2005, vol. 74 (7), 1946-1949
- **ASUKA NAMAI ; SHUNSUKE SAKURAI ; MAKO-TO NAKAJIMA ; TOHRU SUEMOTO ; KAZUYUKI MATSUMOTO ; MASAHIRO GOTO ; SHINYA SASAKI ; SHINICHI OHKOSHI.** *Journal of the American Chemical Society,* 2009, vol. 131, 1170-1173